Europäisches Patentamt

European Patent Office

Office européen des brevets

(11) Publication number: **0 478 839 A1**

# EUROPEAN PATENT APPLICATION

(21) Application number: **90119096.7**

(22) Date of filing: **05.10.90**

(51) Int. Cl.5: **H01L 27/142, H01L 31/0392**

(43) Date of publication of application:
**08.04.92 Bulletin 92/15**

(84) Designated Contracting States:
**DE ES FR GB IT**

(71) Applicant: **Showa Shell Sekiyu Kabushiki Kaisha**
**2-5, Kasumigaseki 3-chome Chiyoda-ku Tokyo(JP)**

(72) Inventor: **Sichanugrist, Porponth, Showa Shell Sekiyu K.K.**
**2-5, Kasumigaseki 3-chome Chiyoda-ku, Tokyo(JP)**
Inventor: **Suzuki, Hirohisa, Showa Shell Sekiyu K.K.**
**2-5, Kasumigaseki 3-chome Chiyoda-ku, Tokyo(JP)**
Inventor: **Nishi, Hirofumi, Showa Shell Sekiyu K.K.**
**2-5, Kasumigaseki 3-chome Chiyoda-ku, Tokyo(JP)**

(74) Representative: **Lehn, Werner, Dipl.-Ing. et al**
**Hoffmann, Eitle & Partner Patentanwälte**
**Arabellastrasse 4**
**W-8000 München 81(DE)**

(54) **Photovoltaic device and process for manufacturing the same.**

(57) The present invention discloses a photovoltaic device having a plurality of photovoltaic regions arranged independently on an insulating substrate plate (1), each photovoltaic region comprising a first electrode layer (2a,2b,2c), a semiconductor layer (3), and a second electrode layer (4a,4b,4c) superposed in this order on the insulating substrate plate, said photovoltaic regions being electrically connected with each other in series by conductive paths each extending from an edge portion of the first electrode layer (2a,2b,2c) of each photovoltaic region to an edge portion of the second electrode layer (4a,4b,4c) of an adjacent photovoltaic region and consisting of an alloy wall made from a melt derived from said first and second electrode layers, each conductive path extending through the first electrode layer in each photovoltaic region, and a process for manufacturing the same.

Fig. 3

## FIELD OF THE INVENTION

The present invention relates to a photovoltaic device for use as a solar cell, photosensor, or the like, and more particularly, to a thin-film photovoltaic device having a plurality of photovoltaic regions connected in series, and also relates to a process for manufacturing the photovoltaic device.

## BACKGROUND OF THE INVENTION

Film-form semiconductor conductive modules which have conventionally been utilized as solar cells, photosensors, etc. have a thin-film construction in which units each having a number of photovoltaic regions connected in series are arranged on the same plane in order that the modules capture as much light as possible in limited spaces and convert the light into electric energy.

There have conventionally been the following two known techniques for connecting electrically in series a plurality of photovoltaic regions arranged on the same plane, each photovoltaic region having a first electrode layer and a second electrode layer opposite to the first electrode layer through a semiconductor layer.

In the first technique, two adjacent photovoltaic regions are connected in series by arranging the photovoltaic regions in such a manner that an edge portion of the second electrode layer of one photovoltaic region comes into contact with an edge portion of the first electrode layer of the other photovoltaic region.

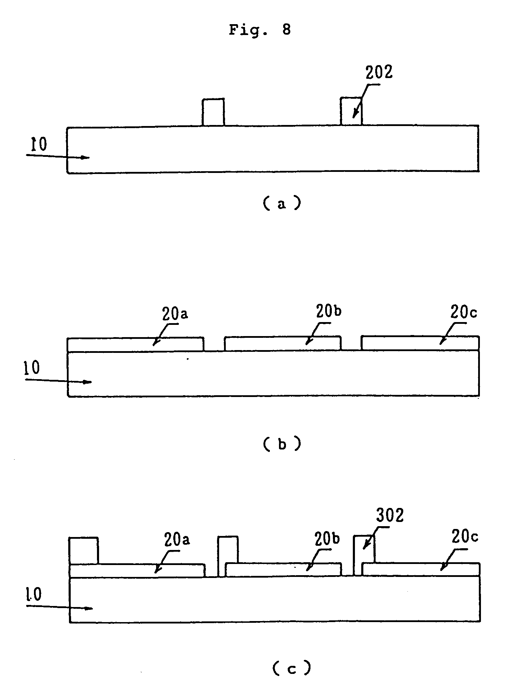

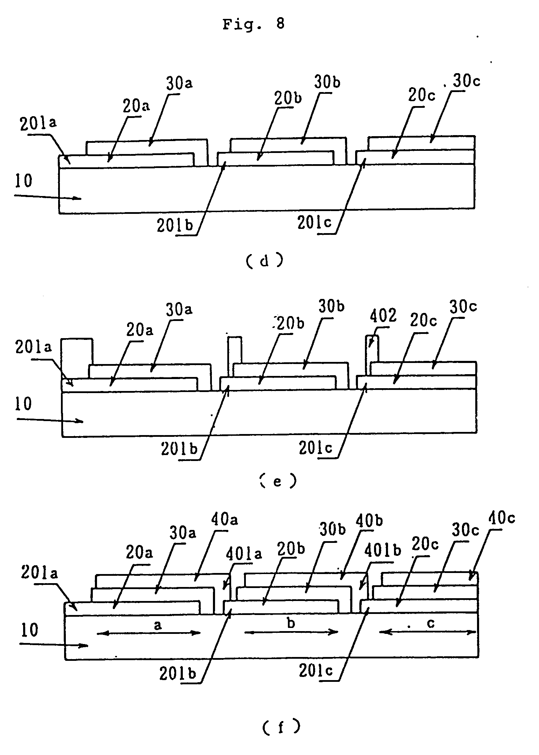

In Fig. 8 (f) is shown a sectional view of a photovoltaic device made by the above technique. A plurality of first electrodes (corresponding to back electrodes) 20a to 20c independent of each other have been formed on a transparent insulating substrate plate 10. Semiconductor layers 30a, 30b, and 30c are formed on the first electrodes 20a, 20b, and 20c, respectively, in such a manner that part of each semiconductor layer comes into contact with the insulating substrate plate. Further, second electrodes 40a, 40b, and 40c are formed on the semiconductor layers 30a, 30b, and 30c, respectively.

The first electrodes 20a to 20c are formed by use of a masking operation or by etching in such a manner that the first electrodes 20b and 20c respectively have edge portions 201b and 201c for connection which extend beyond those areas of the first electrodes 20b and 20c which are to be overlapped by the semiconductor layers 30b and 30c, respectively, and that the first electrode 20a to be a component of a terminal photovoltaic region has an edge portion 201a that serves as an output terminal to which a lead wire is attached. The second electrodes 40a and 40b are formed by means of a masking operation in such a manner that the second electrodes 40a and 40b respectively have edge portions 401a and 401b for connection which extend beyond the semiconductor layers 30a and 30b, respectively, and overlap and contact with the first electrode edge portions 201b and 201c for connection of the adjacent photovoltaic regions b and c, respectively, in the direction perpendicular to the photovoltaic element surface. Thus, the edge portions 201b and 201c for connection of the first electrodes 20b and 20c in the photovoltaic regions b and c are respectively in contact with the edge portions 401a and 401b for connection of the second electrodes 40a and 40b in the respective adjacent photovoltaic regions a and b, and the photovoltaic regions a, b and c are connected electrically in series. Output is obtained between the output terminal edge portion 201a, to which a lead wire is attached, of the first electrode 20a in the photovoltaic region a at one end and the second electrode 40c in the photovoltaic region c at the other end.

The above-described process for manufacturing a conventional photovoltaic device is explained below with reference to the sectional views shown in Fig. 8 (a) to (f) illustrating respective steps.

A transparent insulating substrate plate 10 is cleaned and dried, and is then provided thereon with a mask 202 for forming first electrodes (Fig. 8 (a)). The mask 202 has openings where first electrodes for photovoltaic regions a to c are to be formed.

A transparent conductive film to be first electrodes 20a to 20c is then deposited through the mask 202 by a spraying, plasma CVD, sputtering, or thermal CVD process, or other method. Thereafter, the mask 202 is removed, thereby obtaining first electrodes 20a to 20c arranged on the substrate plate 10 (Fig. 8 (b)).

Subsequently, a mask 302 for forming semiconductor layers is adhered to the substrate plate 10 on the first electrode side (Fig. 8 (c)), and then the resulting structure is placed in a plasma CVD apparatus, where semiconductor layers having a p-i-n junction, for example, are deposited through the mask 302 by glow discharge decomposition. The mask 302 is then removed. Thus, semiconductor layers 30a, 30b, and 30c are formed on the first electrodes 20a, 20b, and 20c, respectively, each of the semiconductor layer being in contact with the substrate plate 10 at one end portion thereof (Fig. 8 (d)).

Thereafter, a mask 402 for forming second electrodes which has openings of predetermined shapes for forming second electrodes 40a and 40b with their respective edge portions 401a and 401b and for forming a second electrode 40c is provided on the semiconductor layers 30a to 30c (Fig. 8 (e)).

Through the mask 402, a metal film to be second electrodes 40a to 40c including their edge portions 401a and 401b is deposited by a sputtering, resistive heating, or electron beam process, or the like. The mask 402 is then removed. Thus, second electrodes 40a, 40b, and 40c including their edge portions 401a and 401b for connection are formed, with the edge portions 401a and 401b for connection being respectively in contact with the edge portions 201b and 201c for connection of the first electrodes 20b and 20c in the adjacent photovoltaic regions b and c (Fig. 8 (f)).

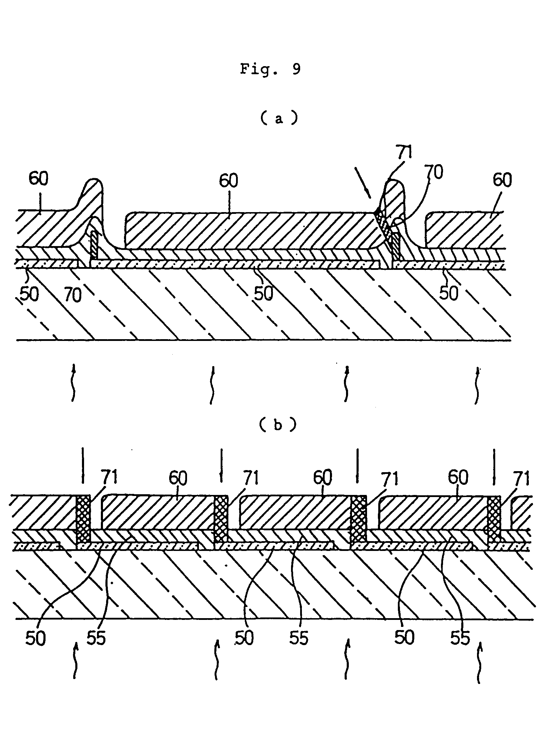

The second technique for connecting a number of photovoltaic regions is disclosed in U.S. Patent 4,517,403, JP-A-62-8578, etc. (The term "JP-A" as used herein means an "unexamined published Japanese patent application".) In this process, as illustrated in Fig. 9 (a), two adjacent photovoltaic regions are arranged in such a manner that an edge portion of the second electrode (corresponding to back electrode) 60 in one photovoltaic region overlaps an edge portion of the first electrode 50 in the adjacent photovoltaic region in the direction perpendicular to the semiconductor element plane, a stitch bar 70 made of silver is provided on the first electrode 50 at its overlapped portion, and the overlapped portion is irradiated with a laser beam from the second electrode 60 side to form a conductive path 71 extending through the second electrode 60 and the semiconductor layer 55. According to a description in the U.S. Patent, the stitch bar 70 made of silver may be omitted and the portion where the first electrode 50 is overlapped by the second electrode 60 may be irradiated with a laser beam in the absence of a stitch bar to form a conductive path 71, as shown in Fig. 9 (b).

However, the first conventional method illustrated in Fig. 8 have the following problems. The photovoltaic device has a very small effective light-receiving area relative to the area of the substrate plate 10, because the total area of the electrode-connecting portions which do not contribute to electric power generation at all comprises 15 to 20% of the whole surface area of the substrate plate 10. This is because in order to attain improved connection reliability, the area of those parts of the edge portions 201 for connection of the first electrodes 20 which are overlapped by the edge portions 401 for connection of the second electrodes 40 is made large by suitably providing the mask 302 so as to make the semiconductor layers 30 not to overlie the edge portions 201 for connection of the first electrodes 20.

Further, since the mask 302 normally is made of metal, the electric field distribution in the plasma is disturbed and interference occurs due to glow discharge during the formation of semiconductor layers, and this results in uneven thickness and quality of the semiconductor layers 30 and impaired output properties and poor appearance of the final product. In addition, since the electrical connection between the first electrodes 20 and the second electrodes 40 is made by mere contacts, or overlapping, between the edge portions 201 for connection of the first electrodes 20 and the edge portions 401 for connection of the second electrodes 40, there are problems such as penetration of moisture and, hence, the photovoltaic device cannot be used with reliability over a prolonged period of time.

The second conventional method described above, i.e., the process illustrated in Fig. 9 (a), is disadvantageous in that the provision of the stitch bars 70 made of silver necessitates excess steps, the structure suffers a distortion when dried at about 700°C after the silver stitch bars 70 are printed, and that the final photovoltaic device has a smaller light-receiving area than the substrate plate by the area occupied by the stitch bars 70.

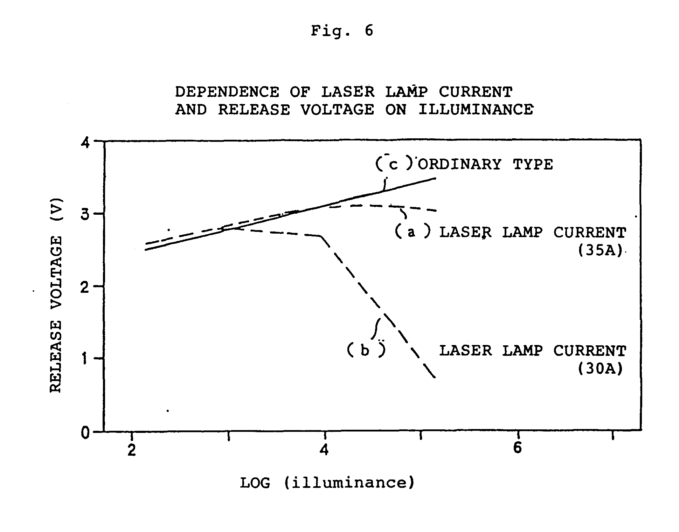

In the case of the process shown in Fig. 9 (b), in which conductive paths 71 are formed between the first electrodes 50 and the second electrodes 60 without the aid of the stitch bars 70, the conductive paths 71 are formed by irradiating the second electrodes 60 to melt the irradiated part of the second electrodes and allowing the molten metal to diffuse into the semiconductor layers 55, and because of this, this photovoltaic device has the following defects. That is, the conductive paths 71 are in mere contact with the first electrodes 50 in this case also, or it is presumed that alloy walls 71a have been formed which extend only to the contact interfaces between the conductive paths 71 and the first electrodes 50 as shown in Fig. 5 (b) that is an enlarged sectional view of an area around a conductive path 71 formed by the process shown in Fig. 9 (b). Therefore, the area in which the conductive paths 71 are in contact with the first electrodes 50 is small and, hence, electrical conduction is unsatisfactory and the photovoltaic device obtained cannot be used with reliability over a prolonged period of time.

SUMMARY OF THE INVENTION

Accordingly, an object of the present invention is to provide a photovoltaic device which is free of the drawbacks accompanying the photovoltaic devices obtained by the above-described conventional techniques, and which has an increased light-receiving area, improved semiconductor layer quality, and improved durability and output properties.

Another object of the present invention is to provide a process for manufacturing the above photovoltaic device.

The above objects of the present invention are accomplished with a photovoltaic device having a plurality of photovoltaic regions arranged independently on an insulating substrate plate, each photovoltaic region comprising a first electrode layer, a semiconductor layer, and a second electrode layer superposed in this order on the insulating substrate plate, said photovoltaic regions being electrically connected with each other in series by conductive paths each extending from an edge portion of the first electrode layer of each photovoltaic region to an edge portion of the second electrode layer of an adjacent photovoltaic region and consisting of an alloy wall made from a melt derived from said first and second electrode layers, each conductive path extending through the first electrode layer in each photovoltaic region,

and a process for manufacturing the above photovoltaic device, which comprises forming a plurality of first electrode layer regions independent of each other on an insulating substrate plate, forming a semiconductor layer over the first electrode layer regions, forming second electrode layer regions on the semiconductor layer in such a manner that each of the second electrode layer regions is opposite to one of the first electrode layer regions through the semiconductor layer thereby to form a plurality of photovoltaic regions, and then heating and melting at predetermined locations the second electrode layer of each photovoltaic region, the semiconductor layer, and the first electrode layer of an adjacent photovoltaic region by irradiation with a laser beam from the second electrode layer side, thereby to form conductive paths in such a manner that the electric powers to be generated in the photovoltaic regions are outputted in series, each of the conductive paths consisting of an alloy wall made from a melt derived from said second and first electrode layers and extending through the first electrode layer.

## BRIEF DESCRIPTION OF THE DRAWINGS

Fig. 1 (a) to (f) are sectional views illustrating the steps of a process for manufacturing a photovoltaic device according to the present invention;
Fig. 2 is a perspective view of one embodiment of the photovoltaic device according to the present invention;
Fig. 3 is a plan view of another embodiment of the photovoltaic device according to the present invention;
Fig. 4 (a) and (b) each is an enlarged perspective view of a conductive path area of a photovoltaic device according to the present invention;
Fig. 5 (a) is a sectional view of a conductive path area of a photovoltaic device according to the present invention;

Fig. 5 (b) is a sectional view of a conductive path area of a photovoltaic device manufactured by a conventional process;
Fig. 6 is a graph showing the dependence of laser lamp current and release voltage on illuminance;
Fig. 7 is a graph showing the relationship between the pulse frequency of laser light and the interval of holes formed in the centers of conductive paths in a photovoltaic device according to the present invention;
Fig. 8 (a) to (f) are sectional views illustrating the steps of the first conventional process for manufacturing a photovoltaic device; and
Fig. 9 (a) and (b) are sectional views of photovoltaic devices manufactured by the second conventional process.

## DETAILED DESCRIPTION OF THE INVENTION

According to the process of the present invention, since irradiation with a laser beam heats not only the second electrode layer and semiconductor layer of each photovoltaic region but also that part of the first electrode layer of an adjacent photovoltaic region which underlies the irradiated part of the second electrode layer, the metallic material of the second electrode and that of the first electrode are melted to give an alloy, which constitutes a conductive path 5 as shown in Fig. 5 (a) which is a sectional view of a conductive path area. Thus, a tight electrical connection is established between the first electrode layer 2 of each photovoltaic region and the second electrode layer 4 of the adjacent photovoltaic region. It is presumed that the laser beam-irradiated portions of the semiconductor layer are changed into fine crystals and also contribute to the formation of the conductive paths along with the alloy formed from the melt derived from the first and second electrode layers.

The photovoltaic device of the present invention is explained below with reference to accompanying drawings.

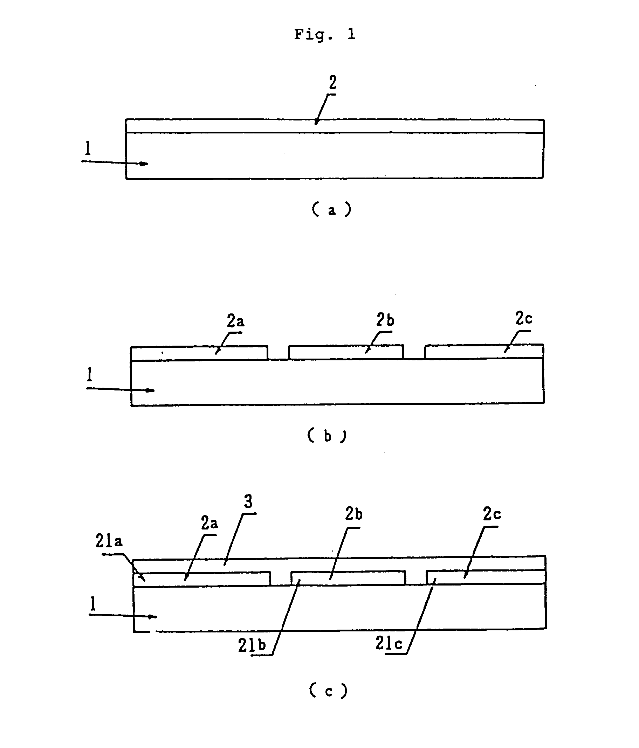

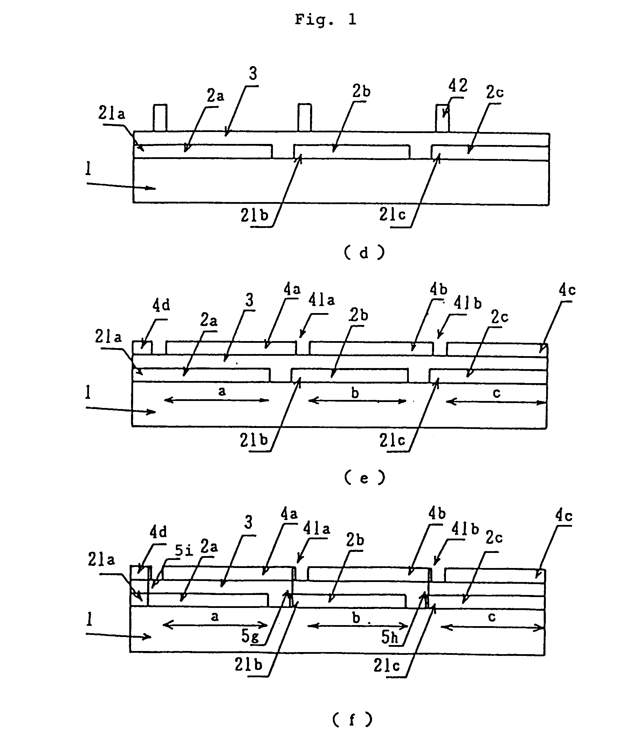

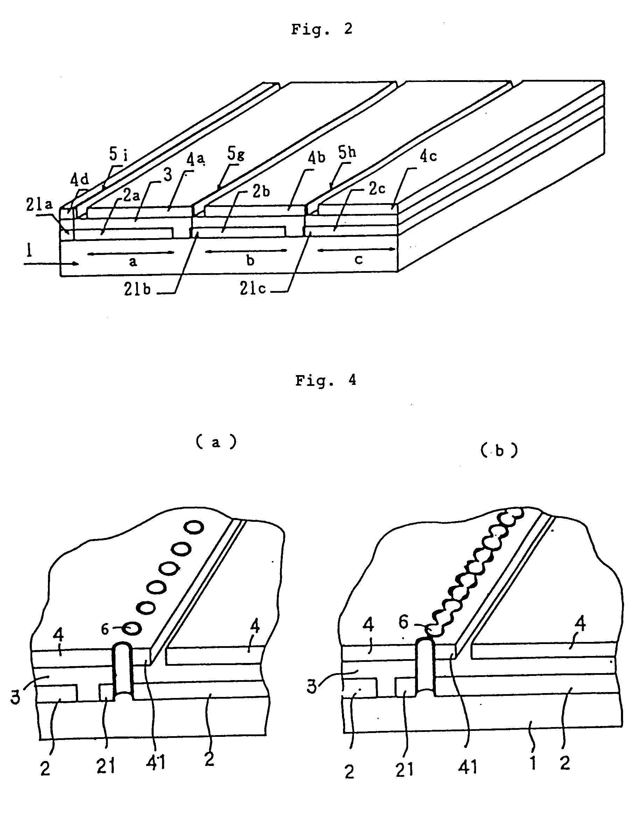

In Fig. 1 (f) and Fig. 2 are respectively shown a sectional view and perspective view of a photovoltaic device manufactured by the process of this invention. A plurality of first electrodes 2a to 2c arranged apart from each other have been formed on a transparent substrate plate 1. An amorphous semiconductor layer 3 has been formed so as to completely cover the first electrodes 2a to 2c. Further, second electrodes 4a to 4c have been provided on the amorphous semiconductor layer 3, the second electrodes 4a, 4b, and 4c being opposite to the first electrodes 2a, 2b, and 2c, respectively, through the semiconductive layer 3, thus forming respective photovoltaic regions. On the edge portion of the amorphous semiconductor layer 3 at one end of the photovoltaic device, an output terminal portion 4d has been formed.

The second electrodes 4a and 4b have edge portions 41a and 41b for connection, respectively. These edge portions 41a and 41b and the output terminal portion 4d have been arranged so as to respectively overlap the edge portions 21b, 21c, and 21a of the first electrodes 2b, 2c, and 2a, respectively, in the direction perpendicular to the photovoltaic element plane. Therefore, when the edge portions 41a and 41b for connection of the second electrodes 4a and 4b and the output terminal portion 4d are irradiated with a laser beam from the second electrode side, the irradiated areas of the second electrodes 4a and 4b and the output terminal portion 4d are melted along with the amorphous semiconductor layer 3 and the first electrodes 2b, 2c, and 2a at the irradiated areas, thereby forming conductive paths 5g, 5h, and 5i, respectively. Each of the conductive paths 5g, 5h, and 5i is made up of a plurality of conductive paths arranged independently along the area where the edge portion 41a or 41b for connection of the second electrode 4a or 4b or the output terminal portion 4d overlaps the edge portion 21b, 21c, or 21a for connection of the first electrode 2b, 2c, or 2a when viewed from the second electrode side in the direction perpendicular to the electrode layer surface, as shown in Fig. 2. Thus, each of the photovoltaic regions on the substrate plate 1 is connected electrically with the adjacent photovoltaic region. Output of the thus-fabricated photovoltaic device, which has the photovoltaic regions a to c connected electrically in series, is obtained between the second electrode 4c in the photovoltaic region c at one end of the device and the output terminal 4d formed on the photovoltaic region a at the other end of the device.

The process of the present invention for manufacturing a photovoltaic device is explained below with reference to the sectional views in Fig. 1 (a) to (f) illustrating respective steps of the process. First, a transparent conductive film 2 to be first electrodes is deposited over a cleaned glass substrate plate 1 at a thickness of about 0.08 to 1.0 $\mu$m (Fig. 1 (a)); the transparent conductive film may be made, for example, of tin oxide, indium tin oxide, zinc oxide, or the like. The substrate plate 1 may be made of a ceramic or stainless steel. Subsequently, the transparent conductive film 2 is partially melted and removed by means of a laser beam, thereby forming on the substrate plate 1 a plurality of first electrodes 2a to 2c having predetermined shapes (Fig. 1 (b)). Alternatively, the first electrodes 2a to 2c may be formed by a conventional process using a mask.

The substrate plate 1 on which the first electrodes 2a to 2c have been deposited is then placed in a plasma CVD apparatus, and an amorphous semiconductor layer 3 having a p-i-n junction is deposited over the substrate plate 1 on the first electrode side by means of glow discharge decomposition (Fig. 1 (c)). For example, the p-layer may be formed by the glow discharge of a gaseous mixture composed of a silane, methane, and diborane, the i-layer by the glow discharge of a silane gas, and the n-layer by the glow discharge of a gaseous mixture composed of a silane, methane, and phosphine. The reaction conditions normally include a substrate plate 1 temperature of about 200°C and a reaction pressure of about 0.1 to 1.0 Torr. The thickness of the thus-obtained amorphous semiconductor layer 3 is generally 0.3 to 1.0 $\mu$m.

Thereafter, a mask 42 for forming second electrodes which has openings of predetermined shapes for forming a plurality of second electrodes 4a to 4c and an output terminal portion 4d is formed on the amorphous semiconductor layer 3 by printing (Fig. 1 (d)). A metallic film to be second electrodes 4a to 4c and an output terminal portion 4d is then deposited through the mask 42 by sputtering or other technique. Aluminum, nickel, etc. may be used as the metal, and the thickness of the metallic film is generally 0.1 to 1 $\mu$m. The mask 42 is then removed, thereby obtaining a plurality of second electrodes 4a to 4c and an output terminal portion 4d of the predetermined shapes (Fig. 1 (e)).

The second electrode edge portions 41a and 41b for connection and the output terminal portion 41d have been formed so as to respectively overlie the first electrode edge portions 21b, 21c, and 21a for connection when viewed from the second electrode side. The second electrode edge portions 41a and 41b for connection and the output terminal portion 41d are irradiated with a laser beam, for example an Nd-YAG laser beam, from the second electrode side, whereby the edge portions 41a and 41b for connection, the output terminal portion 41d, the amorphous semiconductor layer 3, and the first electrode edge portions 21b, 21c, and 21a for connection are melted at the irradiated areas to form conductive paths 5g, 5h, and 5i, respectively (Fig. 1 (f)).

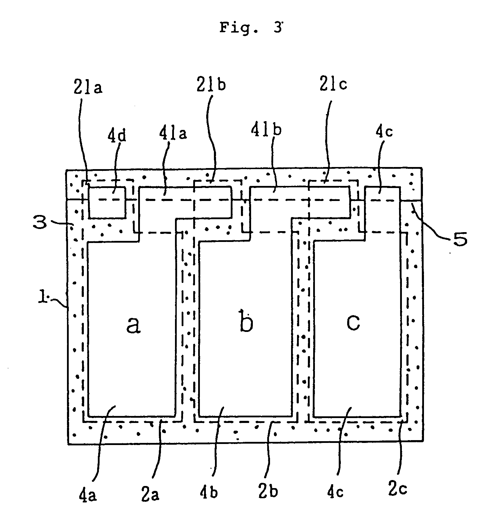

The connecting parts for the photovoltaic regions may be arranged along an edge of the insulating substrate plate as shown in the plan view in Fig. 3.

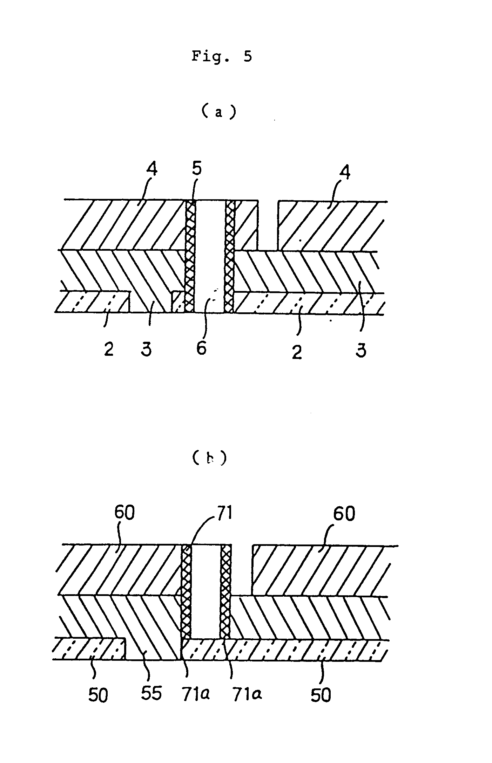

The present inventors have found that photovoltaic regions cannot be connected electrically in series if the frequency of the laser pulse used is too high and that the desired connection is made possible by suitably selecting the frequency. Based on this, it can be thought that by use of laser light having a suitable frequency, a plurality of holes 6 apart from each other are formed as shown in Fig. 4 (a), an enlarged perspective view of a conductive path 5 area, and a metal wall made from a melt derived from the second electrode metal, the amorphous semiconductor, and the first electrode metal is formed around the circumference of each of the holes 6, and that the thus-formed metal walls independent of each other serve as the conductive paths 5. However, if the frequency of the laser pulse is too high, the holes 6 formed at the centers of laser beam-irradiated parts are joined together, as shown in Fig. 4 (b), and as a result, the conductive paths cannot be present in a sufficient amount and cannot exhibit satisfactory conductive performance and, in some cases, the electrodes and semiconductor layer may be cut. It is preferable that in order to form sufficient conductive paths, the conductive paths 5 be provided inside and apart from the edge of each electrode layer, as shown in Fig. 4 (a) and Fig. 5 (a), so as to prevent the metal walls from being wasted.

It is also presumed that as illustrated by the enlarged sectional view in Fig. 5 (a), the first electrode layer and the second electrode layer are partly melted together with the semiconductor layer by the action of heat caused by a laser beam and the melted parts are united to form metal walls constituting the conductive paths, which extend through the first electrode layer to electrically connect the photovoltaic regions. It is further thought that the irradiated parts of the amorphous semiconductor layer 3 are changed into fine crystals and contribute to electrical conduction.

In Fig. 6 is given a graph showing the dependence of laser lamp current and release voltage on illuminance. Curve (c) indicates data for a conventional photovoltaic device of the ordinary type according to Fig. 9 (a) as described above, curve (b) indicates data for a photovoltaic device of the present invention which was prepared by use of laser current of 30 A, and curve (a) indicates data for a photovoltaic device of this invention which was prepared by use of laser current of 35 A.

As Fig. 6 shows, the curve (a) for the photovoltaic device of the invention prepared by use of laser current of 35 A, which is a relatively large value, is closer to the curve (c) for the conventional photovoltaic device of the ordinary type than the curve (b), and hence the photovoltaic device prepared by use of 35-A laser current is usable in a wide illuminance range like the ordinary type. It is, therefore, desirable that in order to form the conductive paths 5 extending through the first electrode metal, the power of the laser beam be as high as possible as long as the laser beam adversely affects.

It can be presumed that use of an increased electric current results in a heightened temperature, which promotes crystallization of the amorphous silicon because the crystallinity of amorphous silicon depends on temperature as is well known, and decreases the resistance of the amorphous silicon. In the manufacture of the preferred photovoltaic device, the laser beam-generating current (laser lamp current) was increased to 35 A, which was a limit to the apparatus.

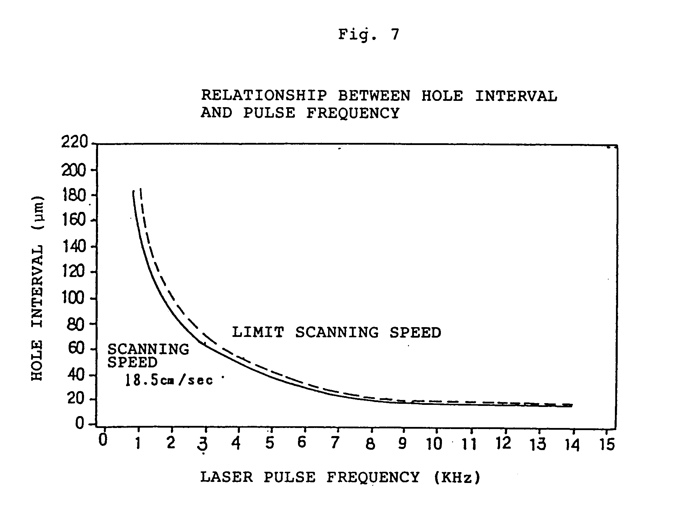

Fig. 7 shows the relationship between laser pulse frequency and the interval of holes 6. In order to elongate the interval of the holes 6, it is necessary to use a laser pulse frequency of 7.4 KHz or less because the holes 6 have diameters of about 25 $\mu$m. Further, it is advantageous to use a higher laser scanning speed relative to the substrate plate 1 in order to increase the hole interval, but the example of the present invention was carried out at a laser scanning speed of 18.5 cm/sec.

In the photovoltaic device obtained by the first conventional technique shown in Fig. 8, the connecting widths of the conductive paths are 0.1 to 1.0 mm. By contrast, according to the present invention, the conductive paths have connecting widths of 20 to 200 $\mu$m and, hence, the widths of the first electrode edge portions 21b and 21c for connection and the second electrode edge portions 41a and 41b for connection can be made small to such an extent that they are slightly larger than the widths of the conductive paths. Therefore, the area of the connecting parts in the photovoltaic device of this invention can be extremely small.

As described above, according to the present invention, the first electrode layer and the second electrode layer are partly melted together with the semiconductor layer by the action of heat caused by a laser beam and the melted parts are united to form metal walls constituting the conductive paths, which extend through the first electrode layer to electrically connect the photovoltaic regions. Therefore, the conductive paths show excellent durability and because the area of the connecting parts where the conductive paths are in contact with the first electrode layer is large, they also have a small electrical resistance. Further, by providing conductive paths for each photovoltaic region in such a manner that they are arranged apart from each other and inside and apart from the edge of each electrode, the metal walls formed from molten metal can be prevented from being wasted and all the metal walls formed can serve as conductive paths, so that the electrical resistance is effectively lowered.

Furthermore, since the semiconductor layer is deposited without using a mask, the resulting semiconductor layer is utterly free of interference which may be caused by a mask and plasma, and has stable film quality and excellent appearance. Moreover, since the electrical connection among the photovoltaic regions is made through the conductive paths having widths, or diameters, as small as 20 to 200 $\mu$m, the area of the connecting parts which do not contribute to electric power generation is smaller than that in the photovoltaic device obtained by the first conventional process (shown in Fig. 8). As a result, the effective light-receiving area and photovoltaic power of the photovoltaic device of this invention are larger or higher than those of the photovoltaic device obtained by the first conventional process by about 3.5 to 5.0% and about 3.5 to 5.0%, respectively.

The photovoltaic device of the present invention can be used as a low-illuminance photoconductive device for use in a desk calculator, a photosensor, etc. In addition, by modifying the manufacturing conditions, for example, increasing the laser beam-generating current, increasing the film thickness of the first electrode so as to enlarge contact area, or increasing the number of conductive paths, the photovoltaic device can be made usable also in high-illuminance applications.

While the invention has been described in detail and with reference to specific embodiments thereof, it will be apparent to one skilled in the art that various changes and modifications can be made therein without departing from the spirit and scope thereof.

## Claims

1. A photovoltaic device having a plurality of photovoltaic regions arranged independently on an insulating substrate plate, each photovoltaic region comprising a first electrode layer, a semiconductor layer, and a second electrode layer superposed in this order on the insulating substrate plate, said photovoltaic regions being electrically connected with each other in series by conductive paths each extending from an edge portion of the first electrode layer of each photovoltaic region to an edge portion of the second electrode layer of an adjacent photovoltaic region and consisting of an alloy wall made from a melt derived from said first and second electrode layers, each conductive path extending through the first electrode layer in each photovoltaic region.

2. A photovoltaic device according to claim 1, wherein the electrical connection between any two adjacent photovoltaic regions is made by a plurality of conductive paths arranged independently along the area where the edge portion of the first electrode layer of one of the two adjacent photovoltaic regions is overlapped by the edge portion of the second electrode layer of the other photovoltaic region through the semiconductor layer when viewed from the second electrode layer side in the direction perpendicular to the electrode layer surface.

3. A photovoltaic device according to claim 1, wherein the conductive paths electrically connecting each photovoltaic region with an adjacent photovoltaic region are provided inside and apart from both the edge of the first electrode layer of each photovoltaic region and the edge of the second electrode layer of the adjacent photovoltaic region.

4. A process for manufacturing a photovoltaic device having, arranged independently on an insulating substrate plate, a plurality of photovoltaic regions each comprising a first electrode layer, a semiconductor layer, and a second electrode layer opposite to the first electrode layer through the semiconductor layer, which comprises forming a plurality of first electrode layer regions independent of each other on the insulating substrate plate, forming a semiconductor layer over the first electrode layer regions, forming second electrode layer regions on the semiconductor layer in such a manner that each of the second electrode layer regions is opposite to one of the first electrode layer regions through the semiconductor layer thereby to form a plurality of photovoltaic regions, and then heating and melting at predetermined locations the second electrode layer of each photovoltaic region, the semiconductor layer, and the first electrode layer of an adjacent photovoltaic region by irradiation with a laser beam from the second electrode layer side, thereby to form conductive paths in such a manner that the electric powers to be generated in the photovoltaic regions are outputted in series, each of the conductive paths consisting of an alloy wall made from a melt derived from said second and first electrode layers an extending through the first electrode layer.

Fig. 1

( a )

( b )

( c )

Fig. 1

(d)

(e)

(f)

Fig. 2

Fig. 4

( a )

( b )

Fig. 3

Fig. 5

(a)

(b)

Fig. 6

DEPENDENCE OF LASER LAMP CURRENT
AND RELEASE VOLTAGE ON ILLUMINANCE

Fig. 7

RELATIONSHIP BETWEEN HOLE INTERVAL
AND PULSE FREQUENCY

Fig. 8

( a )

( b )

( c )

Fig. 8

( d )

( e )

( f )

16

Fig. 9

( a )

( b )

European
Patent Office

EUROPEAN SEARCH
REPORT

Application Number

EP 90 11 9096

# DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | US-A-4 936 924   (T. INUZUKA)<br>* Column 3, line 20 - column 5, line 66; figures 5-12 *<br>– – – | 1,3,4 | H 01 L 27/142<br>H 01 L 31/0392 |
| X | PATENT ABSTRACTS OF JAPAN, vol. 11, no. 288 (E-542)[2735], 17th September 1987;<br>& JP-A-62 89 368 (MATSUSHITA ELECTRIC IND. CO., LTD) 23-04-1987<br>* Whole document *<br>– – – | 1,4 | |
| A | PATENT ABSTRACTS OF JAPAN, vol. 10, no. 50 (E-384)[2107], 27th February 1986;<br>& JP-A-60 206 077 (TAIYOU YUUDEN K.K.) 17-10-1985<br>* Whole document *<br>– – – | 1,3,4 | |
| A | EP-A-0 201 312   (ATLANTIC RICHFIELD CO.)<br>* Page 6, line 24 - page 7, line 24; page 8, line 31 - page 9, line 26; figures 2,3; claim 1 *<br>– – – | 1-4 | |
| E | EP-A-0 422 511   (SHOWA SHELL SEKIYU K.K.)<br>* Whole document *<br>– – – – – | 1-4 | |

| | |
|---|---|
| | TECHNICAL FIELDS SEARCHED (Int. Cl.5) |
| | H 01 L |

The present search report has been drawn up for all claims

| Place of search | Date of completion of search | Examiner |
|---|---|---|
| The Hague | 10 June 91 | VISENTIN A. |